# EUROPÄISCHE PATENTANMELDUNG

(11) **EP 1 589 656 A1**
(43) Veröffentlichungstag der Anmeldung: **26.10.2005**
(21) Anmeldenummer: 05008460.7
(22) Anmeldetag: 19.04.2005
(51) Int. Cl.: H03C 1/14, G06K 19/07

(54) **Verfahren und Schaltung zur Lastmodulation in einer Verbindung aus einem Sendeschwingkreis und einem Empfangsschwingskreis**

(30) Priorität: 22.04.2004 DE 102004020816
(71) Anmelder: ATMEL Germany GmbH, 74072 Heilbronn (DE)
(72) Erfinder: Berhorst, Martin, Dipl.-Ing., 74081 Heilbronn (DE); Schneider, Peter, Dipl.-Phys., 74855 Hassmersheim (DE)

(57) **Zusammenfassung**

Vorgestellt wird eine Schaltung zur Lastmodulation in einem Empfangsschwingkreis (22), der transformatorisch mit einem Sendeschwingkreis koppelbar ist, mit wenigstens einer Induktivität (24), einer Kapazität (26) und einer steuerbaren Impedanz. Die Schaltung zeichnet sich dadurch aus, dass die steuerbare Impedanz wenigstens ein Sperrschichtbauteil (36, 38, 72, 74) und einen Ohm'schen Widerstand (76, 78) aufweist. Ferner wird ein Verfahren zur Lastmodulation vorgestellt.

## Beschreibung

Die Erfindung betrifft ein Verfahren zur Lastmodulation in einer Verbindung aus einem Sendeschwingkreis und einem Empfangsschwingkreis, bei dem eine Spannung an einem Sendeschwingkreis durch Rückwirkung einer Änderung einer Spannung in einem Empfangsschwingkreis moduliert wird.

Darüber hinaus betrifft die Erfindung eine Schaltung zur Lastmodulation in einem Empfangsschwingkreis, der transformatorisch mit einem Sendeschwingkreis koppelbar ist, mit wenigstens einer Induktivität, einer Kapazität und einer steuerbaren Impedanz,

Ein solches Verfahren und eine solche Schaltung sind per se und insbesondere durch RFID-Anwendungen (RFID = Radio Frequency Identification) bekannt. Unter einer RFID-Anwendung wird hier jede Anwendung verstanden, bei der ein Sendeschwingkreis einen induktiv gekoppelten Empfangsschwingkreis mit Energie versorgt und ggf. über den Empfangsschwingkreis Daten ausliest. Solche Verbindungen werden zum Beispiel zur Objektidentifikation verwendet, wobei ein Sendeschwingkreis eines Lesegeräts (reader) über einen Empfangsschwingkreis ein mit einer Marke (einem sogenannten tag) ausgezeichnetes Objekt anspricht und Informationen abruft.

Für die Kontaktaufnahme erzeugt der Sendeschwingkreis des Lesegeräts ein hochfrequentes Magnetfeld, das in einer Induktivität eines Empfangsschwingkreises, der sich in der Nähe des Lesegeräts befindet, eine Wechselspannung induziert. Die in den Empfangsschwingkreis induzierte Wechselspannung wird gleichgerichtet und dient zum Beispiel zur Energieversorgung einer an den Empfangsschwingkreis angeschlossenen integrierten Schaltung. Darüber hinaus wird aus der induzierten Wechselspannung eine Taktfrequenz abgeleitet, die der integrierten Schaltung, also zum Beispiel einem Mikroprozessor und/oder einem Speicherelement als Systemtakt zur Verfügung steht. Durch die Ergänzung der Induktivität des Sendeschwingkreises und/oder des Empfangsschwingkreises mit Kapazitäten, insbesondere mit parallel liegenden Kapazitäten, zu Schwingkreisen werden Resonanzeffekte erzielt, die den Wirkungsgrad der Energieübertragung erheblich verbessern.

Eine Übertragung von Daten vom Lesegerät zum Empfangsschwingkreis (downlink) kann zum Beispiel durch Einschalten und Ausschalten des Magnetfeldes erfolgen. Für einen Datentransport in umgekehrter Richtung vom Empfangsschwingkreis zum Lesegerät wird die sogenannte Lastmodulation verwendet, die eine hinreichende Nähe (Abstand kleiner 0,16 * Wellenlänge) von Sendeschwingkreis und Empfangsschwingkreis voraussetzt. Bei hinreichender Nähe kommt es zur sogenannten transformatorischen Kopplung, bei der sich die Energieaufnahme der Empfangsspule durch eine Rückwirkung auf den Sendeschwingkreis in Spannungsänderungen am Sendeschwingkreis abbildet. Gesteuerte Modulationen der Last, also der Impedanz des Empfangsschwingkreises, rufen daher Spannungsänderungen im Sendeschwingkreis hervor, die für eine Datenübertragung auswertbar sind.

Mit zunehmender Güte der im Empfangsschwingkreis verwendeten Induktivitäten, also mit zunehmendem Verhältnis von Blindwiderstand zu Wirkwiderstand, verringert sich die Dämpfung des Schwingkreises und die Breite der Resonanzkurve. Die Verwendung von Spulen höherer Güte bewirkt also eine höhere Frequenzselektivität und, bei gleicher Spannung auf der reader-Seite, eine höhere Spannung auf der tag-Seite, was die Reichweite der Kommunikationsverbindung vergrößert.

In diesem Zusammenhang ist es per se bekannt, die Spannung am Empfangsschwingkreis auf bestimmte Werte zu reduzieren oder zu begrenzen (Klemmspannungen), wobei im Rahmen der Modulation zwischen zwei Spannungen umgesteuert oder umgeschaltet wird. Dazu werden Sperrschichtbauelemente zwischen Schwingkreisanschlüsse und ein Bezugs- oder Massepotential geschaltet. Eine untere Klemmspannung wird zum Beispiel dadurch realisiert, dass über den Sperrschichtbauelementen deren Durchlassspannung abfällt, wobei der Spannungsabfall wegen der exponentiellen Abhängigkeit des Stroms von der Spannung in erster Näherung stromunabhängig ist. Mit anderen Worten: Anders als bei einem Ohm'schen Widerstand vergrößert sich der Spannungsabfall nicht linear mit dem Stromdurchfluss sondern bleibt auch bei höheren Stromstärken in etwa in der Höhe der Durchlassspannung,

Als Folge wirken die Sperrschichtbauelemente auch bei hohen Spulenströmen wie eine zuverlässige Begrenzung der Schwingkreisspannung auf einen zugehörigen Wert. Dies ist insbesondere bei Systemen mit Induktivitäten hoher Güte von Bedeutung, die bei räumlicher Nähe von Sendeschwingkreis und Empfangsschwingkreis sonst unerwünschte hohe Spannungen verursachen könnten.

Die zweite, obere, Klemmspannung kann durch eine in Reihe mit umgekehrter Durchlassrichtung geschaltete Zenerdiode realisiert sein, die gesteuert oder geschaltet kurzzuschließen ist. Im kurzgeschlossenen Zustand erfolgt die beschriebene Begrenzung auf die untere Klemmspannung, während im nicht kurzgeschlossenen Zustand die Durchbruchspannung der Zenerdiode für einen additiven Spannungsversatz sorgt, der in der Summe mit den genannten Durchlassspannungen eine obere Klemmspannung definiert. Im Zustand mit kurzgeschlossener Zenerdiode fließt ein vergleichsweise großer Strom aus dem Empfangsschwingkreis heraus, was dem belasteten Zustand des Schwingkreises entspricht. Entsprechend wird die Stromentnahme aus dem Schwingkreis sowie die Belastung des Schwingkreises durch Öffnen des Kurzschlusses über der Zenerdiode verringert.

Bei dieser bekannten Lastmodulation ist das folgende Problem beobachtet worden: Wenn beim Einschalten der Modulation, also beim Begrenzen der Schwingkreisspannung auf die untere Klemmspannung, gerade ein hoher Spulenstrom induziert wird, so fließt dieser unter Umständen über die Überbrückung der Zenerdiode und die in Durchlassrichtung geschalteten übrigen Sperrschichtbauteile ab, wobei die Schwingkreisspannung unter den Klemmspannung und auch unter einen Schwellenwert fallen kann, der zur Detektion von Schwingungen (Pulsen) der Schwingkreisspannung dient. Es kann also bei ungünstigen Phasenbedingungen beim Einschalten der Last vorkommen, dass die Spannung am Sendeschwingkreis aufgrund der Rückwirkung für eine oder mehrere Perioden unter eine Detektionsschwelle sinkt, was die Informationsübertragung verfälscht. Dadurch kann es zu einem Datenverlust bei der Informationsübertragung zum Lesegerät kommen.

Wird nämlich bei einem hohen induzierten Spulenstrom die Modulation eingeschaltet, so sorgen die Sperrschichtbauteile für eine Begrenzung der Schwingkreisspannung auf einen durch die Sperrschichtbauteile vorbestimmten Wert. Die Dioden wirken in dieser Phase wie eine Gleichspannungsquelle und setzen somit dem Spulenstrom keine ausreichende Dämpfung entgegen, so dass die induzierte Schwingung verändert wird. Die Folge ist eine Verbreiterung der gerade anliegenden Taktphase (Pulsverbreiterung), die zumindest zur teilweisen Auslöschung der Folgeschwingung führt. Sie tritt dadurch in Erscheinung, dass mindestens eine Schwingung in der Amplitude zu klein für eine vorgegebene Detektionsschwelle ist.

Vor diesem Hintergrund besteht die Aufgabe der Erfindung in der Angabe eines Verfahrens und einer Schaltung, die diesen Nachteil zumindest verringert.

Diese Aufgabe wird sowohl bei einem Verfahren als auch bei einer Schaltung der eingangs genannten Art jeweils dadurch gelöst, dass die Lastmodulation durch gesteuertes Ändern einer Schwingkreis-Impedanz erfolgt, die wenigstens ein Sperrschichtbauteil und einen Ohm'schen Widerstand aufweist.

Durch die lineare Strom/Spannungsabhängigkeit fällt bei einem Stromfluss eine endliche, stromabhängige Spannung über einem Ohm'schen Widerstand ab. Im Gegensatz dazu begrenzt das Sperrschichtbauteil tendenziell den Spannungsabfall auch bei höheren Stromstärken stromunabhängig in etwa auf die Höhe der Durchlassspannung, so dass es ähnlich wie eine Gleichspannungsquelle wirkt. Es hat sich gezeigt, dass gerade diese Kombination von Sperrschichtbauteilen und Ohm'schen Widerständen den Vorteil einer zuverlässigen Spannungsbegrenzung ohne den beschriebenen Nachteil eines Informationsverlustes bei ungünstigen Einschaltbedingungen der Lastmodulation liefert.

Im Rahmen einer Ausgestaltung des Verfahrens ist bevorzugt, dass das Ändern der Schwingkreisimpedanz durch gesteuertes Überbrücken von wenigstens einem Sperrschichtbauteil und/oder des Ohm's chen Widerstands erfolgt.

Beide Möglichkeiten ergeben eine definierte Impedanzänderung, die sich durch eine transformatorisch induktive Rückwirkung auf den Sendeschwingkreis überträgt und daher zur Datenübertragung vom tag zum reader genutzt werden kann.

Mit Blick auf Ausgestaltungen der Schaltung ist bevorzugt, dass die steuerbare Impedanz zwischen einem ersten Schwingkreisanschluss und einem Bezugspotential liegt.

Durch diese Ausgestaltung wird das Potential am Schwingkreisanschluss über die steuerbare Impedanz mit dem Bezugspotential verknüpft und damit gewissermaßen auf definierte, vom Wert der Impedanz abhängige Werte beschränkt, was eine reproduzierbar zuverlässige Datenübertragung durch Lastmodulation erlaubt.

Bevorzugt ist auch, dass die steuerbare Impedanz eine erste steuerbare Impedanz zwischen dem ersten Schwingkreisanschluss und dem Bezugspotential und eine zweite steuerbare Impedanz zwischen einem zweiten Schwingkreisanschluss und dem Bezugspotential aufweist.

Dieser Aufbau einer Schaltung zur Klemmung der Schwingkreispotentiale auf vorbestimmte Werte liefert die genannten Vorteile in verstärktem Maße, da er für eine vorbestimmte Begrenzung der positiven und der negativen Abweichungen der Schwingkreispotentiale von dem Bezugspotential sorgt.

Eine weitere bevorzugte Ausgestaltung zeichnet sich durch eine zum Bezugspotential symmetrische Anordnung und Struktur der ersten steuerbaren Impedanz und der zweiten steuerbaren Impedanz aus.

Dieser symmetrische Aufbau bewirkt, dass Schwingungen Vorzeichen-unabhängig gleich beeinflusst und auf betragsmäßig gleiche Abweichungen von dem Bezugspotential begrenzt werden. Auch dies erhöht die Zuverlässigkeit der Datenübertragung.

Bevorzugt ist auch, dass die steuerbare Impedanz ferner eine schaltbare Überbrückung von wenigstens einem Sperrschichtbauteil und/oder des Ohm'schen Widerstands aufweist.

Durch die schaltbare Überbrückung wird eine Lastmodulation mit geringem Aufwand realisiert.

Ferner ist bevorzugt, dass die schaltbare Überbrückung eine Arbeitsstromstrecke eines Transistors aufweist.

Diese Ausgestaltung liefert eine besonders einfach steuerbare und monolithisch integrierbare Möglichkeit einer Lastmodulation.

Eine weitere bevorzugte Ausgestaltung zeichnet sich dadurch aus, dass die steuerbare Impedanz wenigstens eine Reihenschaltung eines ersten Sperrschichtbauteils und eines Ohm'schen Widerstands aufweist.

Schaltet man zu den Sperrschichtbauteilen einen Ohm'schen Widerstand in Reihe, so dämpft der Widerstand den Spulenstrom bei geeigneter Dimensionierung in dem Maße, daß die erwähnte Pulsverbreiterung und damit auch die teilweise Auslöschung zumindest verringert wird. Infolgedessen sind alle Schwingungen in der Amplitude ausreichend hoch, so dass sie die vorgegebene Detektionsschwelle überschreiten können.

Bevorzugt ist auch, dass die Reihenschaltung zusätzlich zu dem ersten Sperrschichtbauteil wenigstens ein zweites Sperrschichtbauteil aufweist, das mit dem ersten Sperrschichtbauteil in Reihe liegt und das eine Durchlassrichtung besitzt, die einer Durchlassrichtung des ersten Sperrschichtbauteils entgegengesetzt ist.

Durch diese Ausgestaltung lässt sich die Schwingkreisspannung bei der Lastmodulation in beiden Schaltzuständen auf definierte Werte begrenzen. Solange beide Sperrschichtbauteile nicht überbrückt sind, tritt ein Stromfluss bei Überschreiten der Summe aus Durchbruchspannung des einen und Durchlassspannung des anderen Sperrschichtbauteils ein. Wird dagegen das sperrende Bauteil überbrückt, tritt der Stromfluss bei Überschreiten der Durchlassspannung ein. Der Unterschied zwischen der Durchlassspannung und der Summe aus Durchlassspannung und Durchbruchspannung definiert damit den Modulationshub der Lastmodulation im Empfangsschwingkreis.

Eine weitere bevorzugte Ausgestaltung zeichnet sich durch eine Zenerdiode als erstes oder als zweites Sperrschichtbauteil aus.

Zenerdioden besitzen den Vorteil, dass sie dauerhaft im Durchbruchspannungsbereich betrieben werden können.

Bevorzugt ist auch, dass die steuerbare Impedanz eine Parallelschaltung aus wenigstens einem Halbleiterbauteil und einem Ohm'schen Widerstand aufweist.

Durch eine solche Anordnung werden die gewünschten Eigenschaften weiter optimiert. Der Nachteil, dass bei großen Strömen über den Widerstand unerwünscht große Spannungen auftreten, werden durch das parallel liegende Sperrschichtbauteil vermieden, das die auftretende Spannung auf den Wert seiner Durchlassspannung begrenzt.

Eine weitere bevorzugte Ausgestaltung zeichnet sich durch eine Diode als drittes Sperrschichtbauteil aus.

Alternativ wird ein Transistor als drittes Sperrschichtbauteil benutzt, der von einem Spannungsabfall an dem Ohm'schen Widerstand gesteuert wird und dessen Arbeitsstromstrecke wenigstens den Ohm'schen Widerstand überbrückt.

Dabei ist bevorzugt, dass die Arbeitsstromstrecke des Transistors zwischen einem Schwingkreisanschluss und einem Bezugspotential liegt.

Diese Alternative besitzt den besonderen Vorteil, dass der Strom über die Arbeitsstromstrecke direkt zum Bezugspotential, also zum Beispiel zu einem Substratanschluss, fließt. Er fließt dann nicht mehr in die Kette weiterer Bauelemente aus ersten und zweiten Sperrschichtbauelementen hinein, die daher kleiner dimensioniert werden können.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: ein Gesamtsystem aus einem Lesegerät und einer Schaltung mit einem Empfangsschwingkreis;
- Fig. 2: einen bekannten Empfangsschwingkreis mit Elementen zur Lastmodulation;
- Fig. 3: ein gewünschtes Modulationsverhalten;
- Fig. 4: ein problematisches Modulationsverhalten, wie es bei bekannten Schaltungen in Verbindung mit Empfangsinduktivitäten hoher Güte beobachtet wurde;
- Fig. 5: ein erstes Ausführungsbeispiel eines erfindungsgemäßen Schaltungsteils; und
- Fig. 6: ein zweites Ausführungsbeispiel eines erfindungsgemäßen Schaltungsteils.

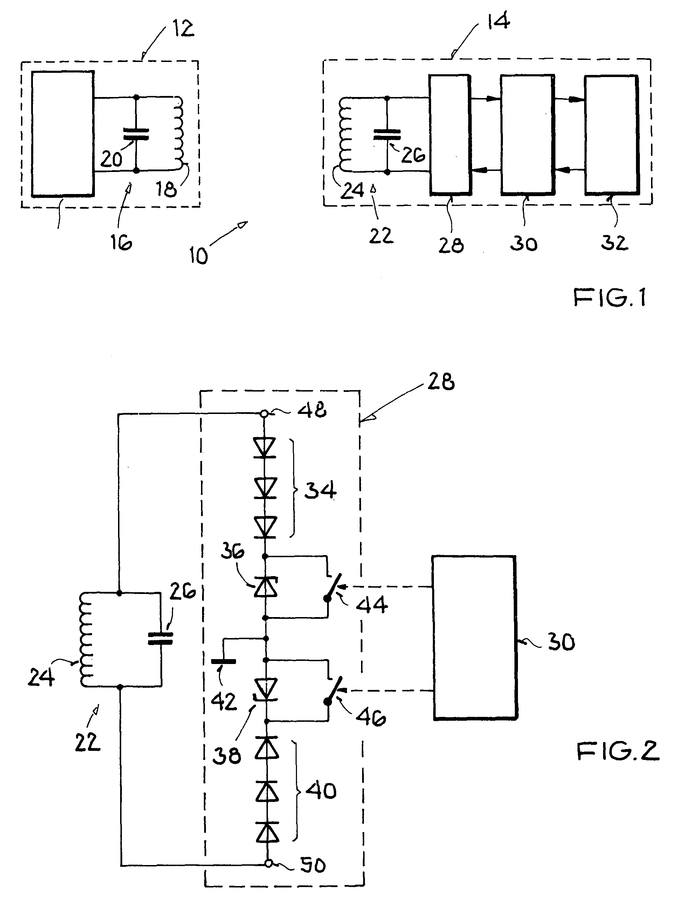

Fig. 1 zeigt ein Gesamtsystem 10 aus einem Lesegerät (reader) 12 und einem Empfangsteil 14, bspw. einer Objektmarke (tag). Das Lesegerät 12 weist einen Sendeschwingkreis 16 auf, der in der schematischen Darstellung der Fig. 1 induktive Elemente 18 und kapazitive Elemente 20 besitzt. Das Empfangsteil 14 weist einen Empfangsschwingkreis 22 auf, der ebenfalls wenigstens eine Induktivität 24 und eine Kapazität 26 besitzt. Weiter weist das Empfangsteil 14 eine Schnittstelle 28 und optional eine Steuerschaltung 30 und/oder einen Speicher 32 auf.

Fig. 2 zeigt den Empfangsschwingkreis 22 zusammen mit Einzelheiten einer bekannten Schnittstelle 28. Parallel zu dem Parallelschwingkreis 22 aus Induktivität 24 und Kapazität 26 liegt eine Reihenschaltung aus oberen ersten Dioden 34, einer Zenerdiode 36, einer weiteren Zenerdiode 38 und unteren ersten Dioden 40. Zwischen den Zenerdioden 36, 38 liegt ein Bezugspotentialanschluss 42, der zum Beispiel ein Massepotential für die Schaltung bereitstellt. Die Zenerdioden 36, 38 können durch Schalter 44, 46 überbrückt werden, die von der Steuerschaltung 30 betätigt werden. Die Schalter 44, 46 werden bevorzugt Transistoren, insbesondere als MOS-Transistoren realisiert.

Die oberen ersten Dioden 34 und die unteren ersten Dioden 40 dienen zur alleinigen Begrenzung der Schwingkreisspannung zwischen Anschlüssen 48, 50 des Empfangsschwingkreises 22 bei geschlossenen Schaltern 44 und 46 und definieren die untere Begrenzungsspannung. In diesem Zustand begrenzen die Dioden 34, 40 jeweils dann, wenn der Potentialunterschied zwischen dem Bezugspotentialanschluss 42 und einem der Anschlüsse 48, 50 die Summe der Durchlassspannungen der Dioden 34 oder 40 überschreitet. Daher wird die Schwingkreisspannung bei überbrückten Zenerdioden 36, 38 durch diese Summe der Durchlassspannungen begrenzt, so dass sich typischerweise ein Wert von 3 * 0,7 = 2,1 Volt für jeweils drei Dioden 34, 40 einstellt.

Bei geöffneten Schaltern 44, 46 muss der Potentialunterschied zwischen dem Anschluss 42 und jeweils einem der Anschlüsse 48, 50 dagegen zusätzlich noch die Durchbruchspannung der Zenerdioden 36, 38 überschreiten, bevor die Schwingkreisspannung auf ein höheres Niveau begrenzt wird. Bei geöffneten Schaltern 44,46 liegt diese Begrenzung unter Annahme einer Durchbruchspannung von 7 V bei 2,1 V + 7 V = 9,1 V. Dieser Wert definiert die obere Begrenzungsspannung.

Durch Öffnen und Schließen der Schalter 44, 46 moduliert die Steuerschaltung 30 den Wert der maximalen Schwingkreisspannung und damit die Impedanz des Empfangsschwingkreises 22. Wie bereits erwähnt, bildet sich diese Modulation der Impedanz des Empfangsschwingkreises als Modulation der Last des Sendeschwingkreises 16 unter der Voraussetzung einer transformatorischen Kopplung (Abstand kleiner 0,16-fache Wellenlänge) in der Klemmenspannung des Sendeschwingkreises 16 ab, was zum Auslesen von Daten aus dem Empfangsteil 14 genutzt werden kann.

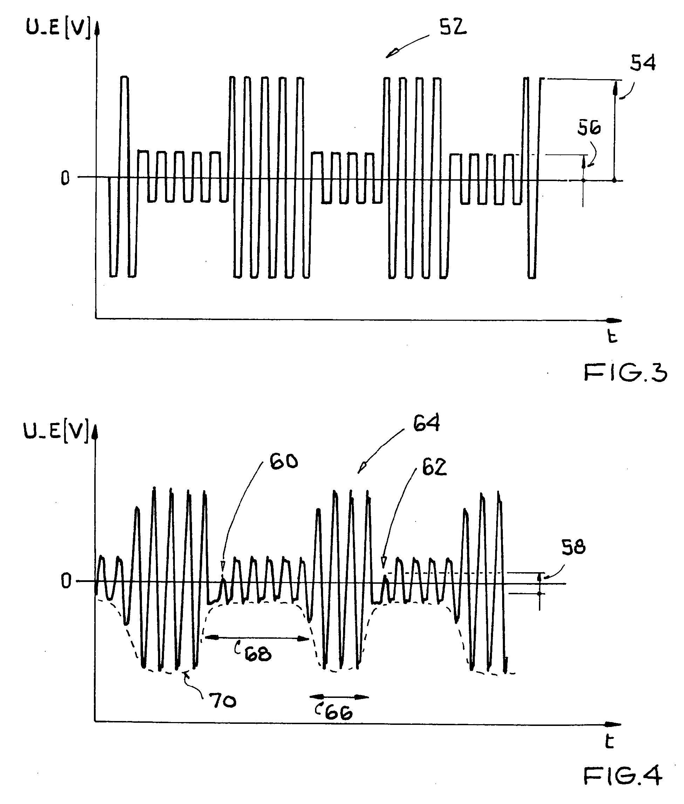

Fig. 3 zeigt einen erwünschten Verlauf 52 der resultierenden Schwingkreisspannung U_E im Empfangsschwingkreis 22 unter dem Einfluss einer solchen gesteuerten Lastmodulation über der Zeit t. Die großen Amplituden 54 stellen sich bei offenen Schaltern 44, 46 aus Fig. 2 ein und die kleinen Amplituden 56 stellen sich bei geschlossen Schaltern 44, 46 ein, mit denen sperrende Zenerdioden 36, 38 aus Fig. 2 überbrückt werden. Mit den im Zusammenhang mit der Fig. 2 genannten Werten beträgt der Wert der kleinen Amplitude 56 2,1 Volt, und der Wert der großen Amplitude 54 beträgt ca. 9,1 Volt.

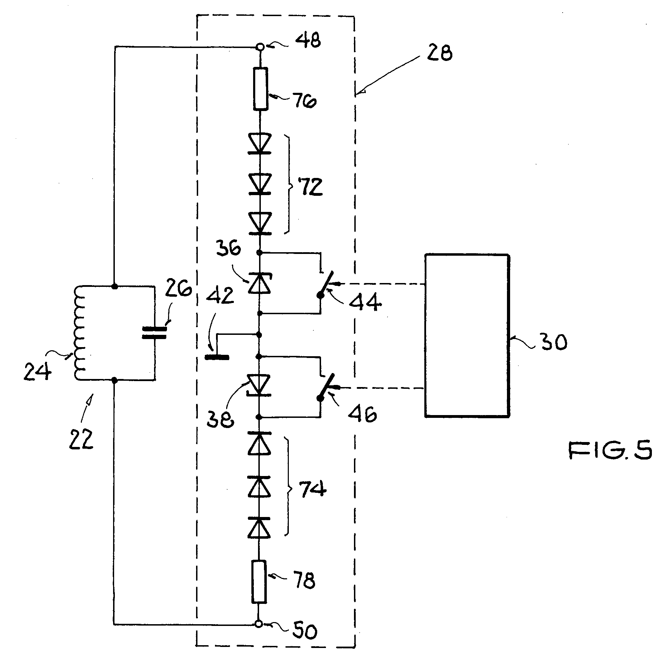

In der Realität zeigt sich aber unter ungünstigen Bedingungen ein unerwünschter Effekt, wie er in der Fig. 4 dargestellt ist. Wenn beim Einschalten der Last-Modulation, also beim Begrenzen der Schwingkreisspannung U_E auf den unteren Klemmpegel gerade ein hoher Spulenstrom induziert wird, so fließt dieser unter Umständen über die Überbrückung der Zenerdiode 36 oder 38 und die in Durchlassrichtung geschalteten übrigen Sperrschichtbauteile 34, 40 ab, wobei die Schwingkreisspannung U_E vorübergehend unter den Klemmpegel und auch unter einen Schwellenwert 58 fallen kann, der zur Detektion von Schwingungen (Pulsen) der Schwingkreisspannung U_E dient. In der Darstellung der Fig. 4 sind solche unzureichend hohen Pulse mit Bezugszeichen 60, 62 im U_E-Verlauf 64 gekennzeichnet.

Üblicherweise zählt die Steuerschaltung 30 des Empfangsteils 14 die Pulse und kodiert die Information für das Lesegerät 12 durch eine Variation der Länge von High-Perioden 66 und/oder Low-Perioden 68 der Hüllkurve 70 des U_E-Verlaufs 64. Dabei bezieht sich "high" oder "low" hier jeweils auf den Absolutbetrag der Signalhöhe. Das Lesegerät 12 registriert die Länge dieser Perioden 66, 68 und rekonstruiert daraus die auszulesende Information. Das fehlerhafte Nicht-Registrieren von Pulsen durch das Empfangsteil 14 führt damit zu einer Verfälschung der zu übertragenden Information.

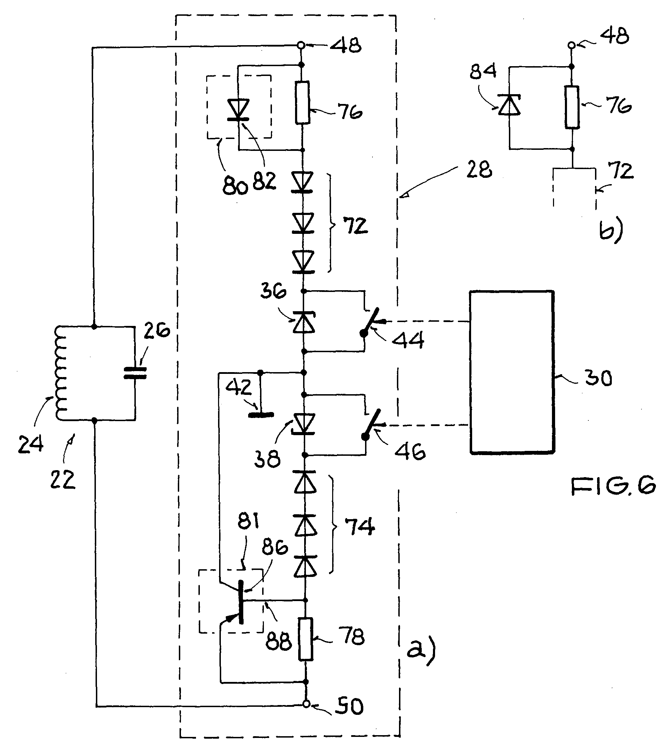

Fig. 5 zeigt ein erstes Ausführungsbeispiel eines erfindungsgemäßen Schaltungsteils, mit dem diese Verfälschung zumindest verringert werden kann. Dabei basiert der Gegenstand der Fig. 5 auf dem Gegenstand der Fig. 3. Neu ist, dass zusätzlich zu ersten Sperrschichtbauelementen 72, 74 wenigstens ein Ohm'scher Widerstand 76 oder 78 zwischen einen Schwingkreisanschluss 48, 50 und dem Bezugspotentialanschluss 42 liegt. Ein Stromfluss über einen der Ohm'schen Widerstände 76, 78 ist zwangsläufig mit einem Spannungsabfall über dem betreffenden Widerstand 76, 78 verknüpft. Als Folge wird auch unter den genannten ungünstigen Bedingungen beim Einschalten der Modulation immer zumindest der Spannungsabfall über diesem Widerstand 76 und/oder 78 aufgebaut, was zu einer zuverlässigen Überschreitung von Detektionsschwellen 58 in Fig. 4 auch beim parallelen Anschwingen und Einschalten einer Lastmodulation führt. Die Sperrschichtbauelemente 72, 74 können den Dioden 34, 40 aus Fig. 3 entsprechen und/oder zum Beispiel als Basis-Emitter-Dioden von Transistoren mit kurzgeschlossenen Kollektor-Basis-Übergängen realisiert sein.

Fig. 6 zeigt ein zweites Ausführungsbeispiel eines erfindungsgemäßen Schaltungsteils. Der Gegenstand der Fig. 6 a unterscheidet sich vom Gegenstand der Fig. 5 unter anderem durch Halbleiterbauteile 80, 81, die Spannungsabfälle an den Widerständen 76, 78 begrenzen. Wie bereits erwähnt, sorgen die Widerstände 76, 78 auch bei dem kritischen Einschalten einer Lastmodulation beim Anschwingen für eine auswertbare Schwingkreisspannungsamplitude. Nachteilig ist, dass große Schwingkreisströme, wie sie zum Beispiel im eingeschwungenen Zustand auftreten können, unerwünscht große Spannungsabfälle über den Widerständen 76, 78 hervorrufen könnten. Um auch dies zu verhindern, begrenzen die Halbleiterbauelemente 80, 81 den Spannungsabfall an den Widerständen 76, 78.

Bei dem Halbleiterbauelement kann es sich zum Beispiel um eine Diode 82 handeln, die parallel zu dem Widerstand 76 zwischen einem Schwingkreisanschluss 48 und den übrigen Elementen der Reihenschaltung, also den ersten Sperrschichtbauelementen 72 und den zweiten Sperrschichtbauelementen (Zenerdioden) 36 aus Fig. 5 liegt. Dies ist für das Halbleiterbauelement 80 in der Fig. 6a dargestellt.

Alternativ kann das Halbleiterbauelement 80 als Zenerdiode 84 realisiert sein, wie sie in Fig. 6b dargestellt ist.

Weiter alternativ kann das Halbleiterbauelement auch als Transistor 86 realisiert sein, wie es in der Fig. 6 a in Verbindung mit dem Widerstand 78 für den Fall des Halbleiterbauelements 81 dargestellt ist. Bei einer Ausführung als Transistor 86 wird die Arbeitsstromstrecke vorteilhafterweise zwischen jeweils einen der Schwingkreisanschlüsse 48, 50 und den Bezugspotentialanschluss 42 geschaltet und ein Steueranschluss 88 des Transistors 86 mit dem Widerstand 76, 78 verbunden. In der Fig. 6 ist eine Ausführung mit einer Diode 82 über dem Widerstand 76 und einem Transistor 86 über dem Widerstand 78 dargestellt. Es versteht sich aber, dass die Ausführung auch symmetrisch erfolgen kann, wobei beide Widerstände 76, 78 dann um gleichartige Halbleiterbauelemente 80 oder 81 ergänzt werden.

Ein hinreichend großer Spannungsabfall über dem Widerstand 78 steuert dann die Arbeitsstromstrecke des Transistors 86 leitend, was einen Stromanstieg über den Widerstand 78 und damit den Spannungsabfall über dem Widerstand 78 wirkungsvoll begrenzt.

Dadurch, dass die Arbeitsstromstrecke direkt auf den Bezugspotentialanschluss 42 geführt wird, fließt der am Widerstand 78 vorbeigeführte Strom nicht mehr in die verbleibende Kette aus ersten und zweiten Sperrschichtbaulementen 74, 38 hinein, die als erwünschte Folge kleiner dimensioniert werden können. Es versteht sich, dass der Transistor 86 sowohl als MOS-Transistor als auch als Bipolartransistor ausgeführt sein kann.

## Patentansprüche

1. Verfahren zur Lastmodulation in einer Verbindung aus einem Sendeschwingkreis (16) und einem Empfangsschwingkreis (22), bei dem eine Spannung an dem Sendeschwingkreis (16) durch Rückwirkung einer Änderung einer Spannung (U_E) in dem Empfangsschwingkreis (22) moduliert wird, **dadurch gekennzeichnet, dass** die Lastmodulation durch gesteuertes Ändern einer Empfangsschwingkreis-Impedanz erfolgt, die wenigstens ein Sperrschichtbauteil (34, 36, 38, 40; 72, 74; 80, 81, 82, 84, 86) und einen Ohm'schen Widerstand (76, 78) aufweist.

2. Verfahren nach Anspruch 1, **dadurch gekennzeichnet, dass** das Ändern der Empfangsschwingkreisimpedanz durch gesteuertes Überbrücken von wenigstens einem Sperrschichtbauteil (34, 36, 38, 40; 72, 74; 80, 81, 82, 84, 86) und/oder des Ohm'schen Widerstands (76, 78) erfolgt.

3. Schaltung zur Lastmodulation in einem Empfangsschwingkreis (22), der transformatorisch mit einem Sendeschwingkreis (16) koppelbar ist, mit wenigstens einer Induktivität (24), einer Kapazität (26) und einer steuerbaren Impedanz, **dadurch gekennzeichnet, dass** die steuerbare Impedanz wenigstens ein Sperrschichtbauteil (34, 36, 38, 40; 72, 74; 80, 81, 82, 84, 86) und einen Ohm'schen Widerstand (76, 78) aufweist.

4. Schaltung nach Anspruch 3, **dadurch gekennzeichnet, dass** die steuerbare Impedanz zwischen einem ersten Schwingkreisanschluss (48) und einem Bezugspotentialanschluss (42) liegt.

5. Schaltung nach Anspruch 4, **dadurch gekennzeichnet, dass** die steuerbare Impedanz eine erste steuerbare Impedanz zwischen dem ersten Schwingkreisanschluss (48) und dem Bezugspotentialanschluss (42) und eine zweite steuerbare Impedanz zwischen einem zweiten Schwingkreisanschluss (50) und dem Bezugspotentialanschluss (42) aufweist.

6. Schaltung nach Anspruch 5, **gekennzeichnet durch** eine zum Bezugspotentialanschluss (42) symmetrische Anordnung und Struktur der ersten steuerbaren Impedanz und der zweiten steuerbaren Impedanz.

7. Schaltung nach wenigstens einem der Ansprüche 3 bis 6, **dadurch gekennzeichnet, dass** die steuerbare Impedanz ferner eine schaltbare Überbrückung von wenigstens einem Sperrschichtbauteil (36, 38) und/oder des Ohm'schen Widerstands (76, 78) aufweist.

8. Schaltung nach Anspruch 7, **dadurch gekennzeichnet, dass** die schaltbare Überbrückung eine Arbeitsstromstrecke eines Transistors aufweist.

9. Schaltung nach wenigstens einem der Ansprüche 3 bis 8, **dadurch gekennzeichnet, dass** die steuerbare Impedanz wenigstens eine Reihenschaltung eines ersten Sperrschichtbauteils (72, 74) und eines Ohm'schen Widerstands (76, 78) aufweist.

10. Schaltung nach Anspruch 9, **dadurch gekennzeichnet, dass** die Reihenschaltung zusätzlich zu dem ersten Sperrschichtbauteil (72, 74) wenigstens ein zweites Sperrschichtbauteil (36, 38) aufweist, das mit dem ersten Sperrschichtbauteil (72, 74) in Reihe liegt und das eine Durchlassrichtung besitzt, die einer Durchlassrichtung des ersten Sperrschichtbauteils (72, 74) entgegengesetzt ist.

11. Schaltung nach Anspruch 10, **gekennzeichnet durch** eine Zenerdiode als zweites Sperrschichtbauteil (36, 38).

12. Schaltung nach wenigstens einem der Ansprüche 3 bis 11, **dadurch gekennzeichnet, dass** die steuerbare Impedanz eine Parallelschaltung aus wenigstens einem Halbleiterbauteil (80, 81) und einem Ohm'schen Widerstand (76, 78) aufweist.

13. Schaltung nach Anspruch 12, **gekennzeichnet durch** eine Diode (82) als Halbleiterbauteil (80, 81).

14. Schaltung nach Anspruch 12, **gekennzeichnet durch** einen Transistor (86) als Halbleiterbauteil (80, 81), der von einem Spannungsabfall an dem Ohm'schen Widerstand (76, 78) gesteuert wird und dessen Arbeitsstromstrecke wenigstens den Ohm'schen Widerstand (76, 78) überbrückt.

15. Schaltung nach Anspruch 14, **dadurch gekennzeichnet, dass** die Arbeitsstromstrecke des Transistors (86) zwischen einem Schwingkreisanschluss (48, 50) und einem Bezugspotentialanschluss (42) liegt.
